# EUROPEAN PATENT SPECIFICATION

(11) **EP 2 171 120 B1**
(45) Date of publication and mention of the grant of the patent: **21.08.2013**
(21) Application number: 08836603.4
(22) Date of filing: 09.06.2008
(51) Int. Cl.: C23C 14/14, C23C 4/12, C23C 24/10, B22F 3/105, C23C 14/04

(54) **SYSTEM AND METHOD FOR COMPONENT MATERIAL ADDITION**
SYSTEM UND VERFAHREN ZUM HINZUFÜGEN EINES KOMPONENTENMATERIALS
SYSTÈME ET PROCÉDÉ POUR RÉALISER UN APPORT DE MATÉRIAU SUR UN COMPOSANT

(30) Priority: 08.06.2007 US 933897 P
(43) Date of publication of application: 07.04.2010
(73) Proprietor: Rolls-Royce Corporation, Indianapolis, IN 46241 (US)
(72) Inventor: KRAUSE, Gregory, Thomas, Indianapolis IN 46242 (US); KEICHER, Dave, Albuquerque, NM 87107 (US); TUCKER, Ed, Albuquerque, NM 87107 (US)
(74) Representative: Beyer, Andreas
(86) International application number: PCT/US2008/007310
(87) International publication number: WO 2009/045239

(56) References cited:
- EP-A2- 1 743 729
- US-A- 4 581 248
- US-A- 4 814 575
- US-A- 5 760 362
- US-A- 5 889 254
- US-A- 5 993 550
- US-A- 6 099 522
- US-A1- 2006 144 827
- US-A1- 2007 093 002
- US-B1- 6 183 817

## Description

The present invention relates to a system and a method for component material addition.

US patent 5 993 550 discloses a photoionic microhead device for the treatment of a material surface by powder deposition. The system includes an optical fiber, a light source able to produce a pulsed light, means for injecting light into a first end of the optical fiber, a miniaturized photoionic head fixed to a second end of the optical fiber and ensuring the diffusion of the light propagated by the optical fiber towards the material to be deposited, a powder reservoir and a gas reservoir and a confinement ring having two nozzles positioned between the photoionic head and the material to be treated in order to ensure the ionization of the dispersed powder.

### Field of the Invention

The present invention relates generally to component repair, and more particularly relates to metal powder deposition utilizing a laser.

### Background

Metal powder deposition to repair and/or modify components is known in the art. However, presently available systems have some disadvantages when repairs or modifications involve complex parts and/or parts with physically limited tool path approaches such as narrow channels or spaces. Further, it is desirable when modifying complex parts to have a good visualization of the modification area. Accordingly, there is a demand for further improvements in this area of technology.

### Summary

The present invention relates to a system according to claim 1 and a method according to claim 15.

### Brief Description of the Drawings

The description herein makes reference to the accompanying drawings wherein like reference numerals refer to like parts throughout the several views, and wherein:
Fig. 1 is a schematic block diagram of a system for component material addition.
Fig. 2A is a schematic diagram of a deposition device and a component.
Fig. 2B is a schematic diagram of a deposition device and a component.
Fig. 3 is a schematic diagram of a deposition device including coaxial optics.
Fig. 4 is a schematic flow diagram of a procedure for component material addition.

### Detailed Description

For purposes of promoting an understanding of the principles of the invention, reference will now be made to the embodiments illustrated in the drawings and specific language will be used to describe the same. It will nevertheless be understood that no limitation of the scope of the invention is thereby intended, such alterations and further modifications in the illustrated device, and such further applications of the principles of the invention as illustrated therein being contemplated as would normally occur to one skilled in the art to which the invention relates.

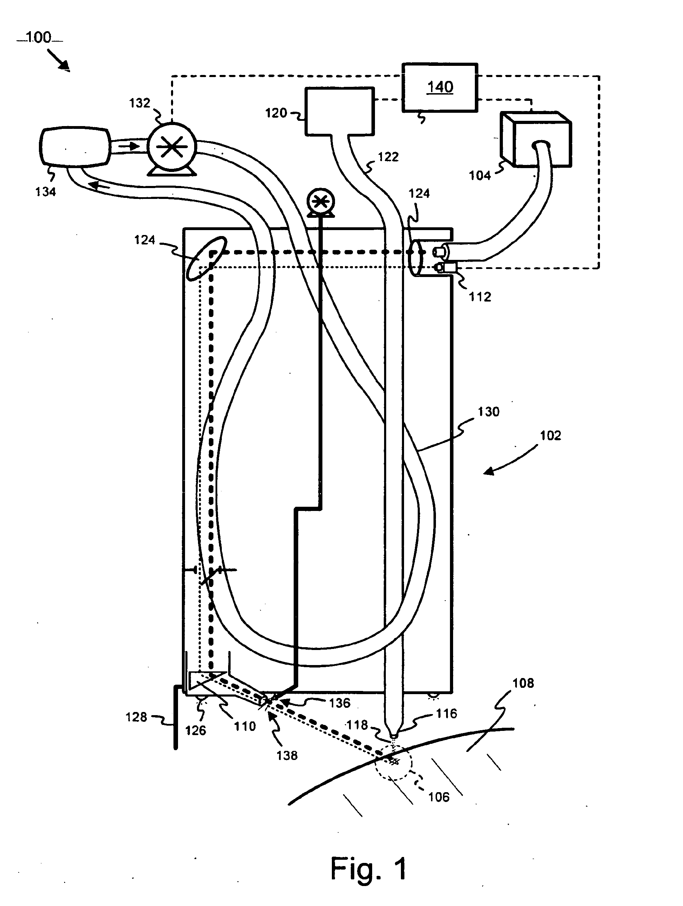

Fig. 1 is a schematic block diagram of a system 100 for component material addition. The system 100 includes a deposition device 102 operatively coupled to a laser 104. The laser may include any type of laser with an irradiation specification high enough to perform material addition operations at a focal area 106 of a component 108. In certain embodiments, the laser is a Nd:YAG laser, and in certain further embodiments the laser is a Nd:YAG fiber laser where the fiber is the lasing gain media. In certain embodiments, the deposition device 102 includes directing optics 110 that focus the laser 104 at the focal area 106 of the component. In certain further embodiments, the directing optics 110 include a prism. The prism allows the use of a higher intensity laser 104 than allowed by conventional coated optics. The prism further turns the laser as shown in Fig. 1, allowing the directing optics 110 to be placed away from a laser generated vapor plume (not shown) that may rise from the component 108 surface during lasering operations.

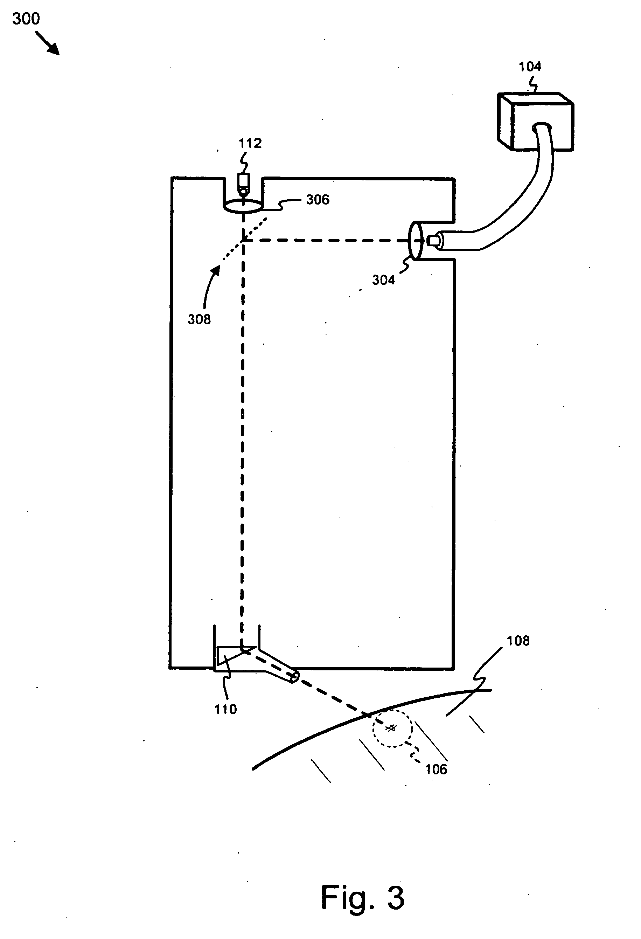

The system 100 further includes an imaging device 112, for example a digital camera or imaging circuit, to view the focal area 106 of the component 108. In certain embodiments, the laser 104 and the imaging device 112 utilize a turning mirror 114 within the deposition device 102, and the laser 104 and imaging device 112 may be in slight parallax as shown in the illustration of Fig. 1. However, the view of the imaging device 112 and the beam location of the laser 104 may be coaxial in certain embodiments (see, e.g., Fig. 3 and referencing text). In certain embodiments, one or more of the laser 104 and imaging device 112 may be configured with an optical line (either beaming or imaging) directly to the directing optics 110 without using a turning mirror 114. In certain embodiments, the placement of any optics 110, 124, the laser 104, and the imaging device 112 are such that the laser 104 and imaging device 112 have a substantially similar optical relationship to the focal area 106.

The system 100 further includes an additive material delivery device that delivers additive material 118 to the component 108 at the focal area 106. In certain embodiments, the additive material delivery device includes a metal powder storage 120, a delivery tube or conduit 122, and a delivery nozzle 116. In certain further embodiments, the additive material 118 is titanium or a titanium alloy.

In certain embodiments, the system 100 includes final focusing optics 124 structured to focus the laser to a specified beam size. In certain embodiments, depending upon the quality of the laser beam, the final focusing optics 124 may need to be placed close to the focal area 106 of the component 108. A fiber optic Nd:YAG laser has a high beam quality on the order of 1 mm-mrad, and can have final focusing optics 124 more than a centimeter up to a few inches from the focal area 106 (for example as shown in Fig. 1) for operations with typical irradiation requirements such as metal powder deposition on a titanium blisk component 108. In certain embodiments, the final focusing optics 124 include a focal length greater than 40 cm. A standard Nd:YAG laser has a beam quality on the order of 12 mm-mrad, and may require final focusing optics 124 in the deposition device 102 near the directing optics 110 to meet irradiation requirements for a metal powder deposition application.

In certain embodiments, the focal area 106 of the component 108 is between blades on a bladed wheel such as a blisk. The focal area 106 may be an area wherein external viewing, for example direct observation by an operator, is difficult or impossible. In certain embodiments, the distance between blades on the blisk is less than one inch, and the deposition device 102 has a width of less than one inch. In certain embodiments, the imaging device 112 views the focal area 106 of the component 108 down the axis, or longest dimension, of the deposition device 102. For example, the imaging device 112 may be externally positioned (not shown) on the deposition device 102 to view the focal area 106 down the length of the deposition device 102. In certain embodiments, the imaging device 112 views the focal area 106 of the component 108 through the direction optics 110. In certain embodiments, the imaging device 112 views the focal area 106 of the component 108 from a close proximity to the component 108, preferably from a distance not greater than the depth of field of the laser 104. In certain embodiments, the imaging device 112 views the focal area 106 of the component 108 from not more than two inches away. The distance from which the imaging device 112 is considered to be viewing the focal area 106 of the component 108 depends upon the optics 110, 124 utilized, the magnification and focal area 106 size. In certain embodiments, the distance from which the imaging device 112 is considered to be viewing the focal area 106 of the component 108 is the distance from the final viewing optics (the direction optics 110 in Fig. 1) to the focal area 106.

The system 100 may include a lighting device 126 that delivers light to the component 108 at the focal area 106 of the component 108. In certain embodiments, the size and complexity of the component 108 prevents external lighting from reaching the focal area 106 of the component 108. The deposition device 102 may include external lights (not shown) shining down the axis of the deposition device 102. In certain embodiments, the deposition device 102 includes light emitting diodes (LEDs) at the end of the deposition device 102 that light the focal area 106 of the component 108. in certain embodiments, the deposition device 102 includes laser diodes (not shown) at the end of the deposition device 102 that light the focal area 106 of the component 108.

In certain embodiments, the laser 104 has an irradiance value greater than 2 MW/cm² at the focal area 106 of the component. A high irradiance value improves heat transfer efficiency to the component 108 reducing reflected heat from the surface. Lower irradiance values, for example according to a specified value for a metal powder deposition operation, may be utilized in certain embodiments. In certain embodiments, a shield 128 is coupled to the deposition device 102. The shield 128 is structured to prevent a reflected portion of the laser light from melting an opposing surface (e.g. a neighboring blisk blade) to the focal area 106.

In certain embodiments, the system 100 further includes a cooling passage 130 that allows coolant to pass through the deposition device 102 and dissipate heat. For example, heat may be reflected from the laser 104 at the focal area 106 back onto the deposition device 102. The coolant may be circulated through the cooling passage 130 with a coolant pump 132 from a coolant storage 134.

In certain embodiments, purge gas delivery device, which may include a gas delivery nozzle 136, is aimed across the directing optics 110 and a shield gas 138 flows across the directing optics 110. The shield gas 138 prevents debris and smoke from the focal area 106 from contaminating the directing optics 110, and in certain further embodiments improves the heat transfer environment of the deposition device 102. The purge gas 138 may be an inert gas for example argon or nitrogen, or in certain embodiments the purge gas 138 may be air.

In certain embodiments, the system 100 further includes a processing subsystem that may include a controller 140. The controller 140, which may represent one or more processing units, hardware memory devices, and/or other computing equipment, communicates with various sensors and actuators throughout the system 100. The controller 140 may be a discrete device or distributed across several devices. The controller 140 may be structured to functionally execute one or more steps of a procedure to repair a component 108. In certain embodiments, the controller 140 may interpret signals from the imaging device 112, various sensors including temperature sensors throughout the system 100 and position sensors of the component 108 and/or deposition device 102, and/or the controller 140 may command various actuators including actuators for the laser 104, the pumping device 132, a purge gas 138 supply, and/or a device for delivery of the additive material 118. The controller 140 may be further structured to record various system 100 parameters, including the position of the deposition device 102 in a "teach-and-learn" operation, wherein the position of the deposition device 102 may be stored in an absolute coordinate system and/or a relative coordinate system (e.g. relative to the component 108 or other device).

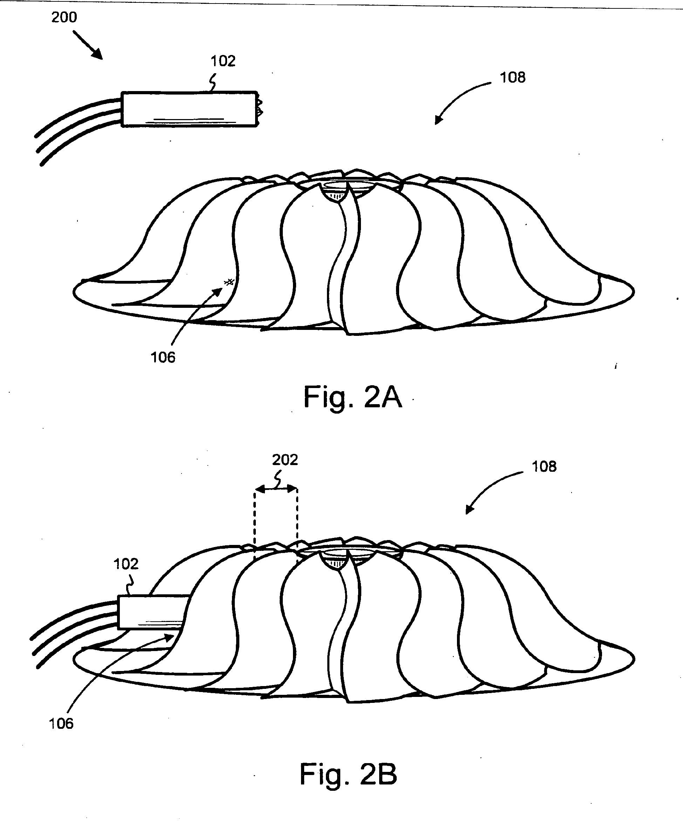

Fig. 2A is a schematic diagram of a deposition device 102 and a component 108. In the illustration of Fig. 2A, the deposition device 102 is in the proximity of the component 108, and a focal area 106 to be repaired is between two blades of a blisk (i.e. the component 108). The blades include a width 202 between the blades that in certain embodiments may be less than one inch. The deposition device 102 includes a width that may be less than one inch.

Fig. 2B is a schematic diagram of a deposition device 102 and a component 108. In the illustration of Fig. 2B, the deposition device 102 is inserted between the blades near the focal area 106. The deposition device 102 is structured to be narrow enough to reach the focal area 106 while having features to illuminate and visualize the focal area 106. The deposition device 102 is further structured, with an efficient laser 104 and/or a heat shield 128, to prevent damaging areas of the component 108 that are near the repair area but that are not the direct subject of the repair operation.

Fig. 3 is a schematic diagram of a deposition device 102 including coaxial optics 302. Certain details that may be present in embodiments of the present application are not shown in Fig. 3 to avoid obscuring the details that are described in Fig. 3. In certain embodiments, the device includes a first focusing lens 304 for the laser 104, a second focusing lens 306 for the imaging device 112, and a beam splitter 308 that allows light from the focal area 106 through to the imaging device 112 but that acts as a turning mirror for the laser 104. The use of a beam splitter 308 allows the imaging device 112 and the laser 104 to operate co-axially, without any parallax. In certain embodiments where high resolution repair is critical, a co-axial embodiment may be preferred as illustrated in Fig. 3. The beam splitter 308 may be utilized to reflect the laser 104 as shown in Fig. 3, or to reflect to the imaging device 112 (not shown) depending upon the size of the laser 104 and imaging device 112, the properties of the laser 104 and the beam splitter 308, the most convenient arrangement for constructing the deposition device 102, and similar considerations that will be understood to those of skill in the art based on the disclosures herein.

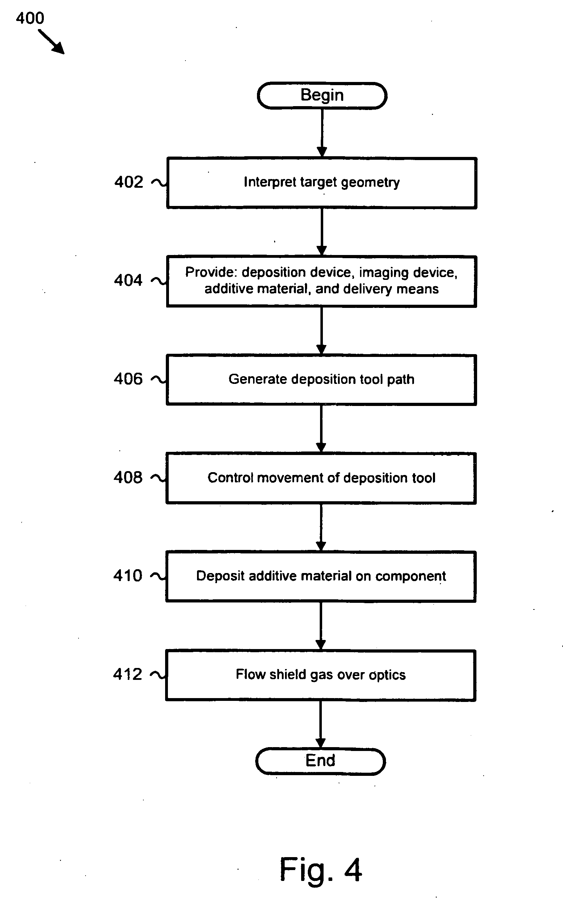

Fig. 4 is a schematic flow diagram of a procedure 400 for component material addition. The procedure 400 includes an operation 402 to interpret a target geometry for a component 108. Interpreting the target geometry includes determining a geometry based on a manufacturer specification, determining a geometry by extrapolating a geometry of the undamaged areas of the component through the damaged area of the component, an operator programming a target geometry into a computer, or any other operations that conclude with a determination of a target geometry of the component 108 through a damaged area. The procedure 400 further includes an operation 404 to provide a deposition device 102, an imaging device 112, and a additive material delivery means which may include a laser 104, powder delivery system, purge gas, coolant delivery, etc.

The procedure 400 further includes an operation 406 to generate a deposition tool path. Generating the deposition tool path may include programming the tool path based on the target geometry of the component 108, for example by imaging the exact position of the component 108 on a coordinate system, calculating a deposition path, and programming the deposition device 102 to follow the tool path. In certain embodiments, generating the deposition tool path includes performing a "teach-and-learn" operation. For example, an operator may move the deposition device (e.g. with the laser 104 off) through the path which will perform the repair operation, and a computer may record the path the operator utilizes as the generated deposition tool path. Any operations known in the art to generate a deposition tool path utilizing the target geometry of the component 108 are contemplated in the present application.

The procedure 400 further includes an operation 408 to control movement of the deposition device 102 through the deposition tool path. In certain embodiments, a computer controls the deposition device 102 through the generated deposition tool path. In certain embodiments, an operator controls the deposition device 102 through the generated deposition tool path. In certain embodiments, an operator generates the deposition tool path by viewing the focal area 106 through the imaging device 112, and moves the deposition device 102 through the deposition tool path as the tool path is generated. The procedure 400 further includes an operation 410 to deposit additive material 118 on the component 108. The operation 410 may include a metal powder deposition operation utilizing a laser 104. In certain embodiments, the procedure 400 further includes an operation 412 to flow a shield gas 138 over the directing optics 110.

As is evident from the figures and text presented above, a variety of embodiments according to the present invention are contemplated.

A system is disclosed including a deposition device operatively coupled to a laser, the deposition device comprising directing optics structured to direct the laser at a focal area on a component, an imaging device structured to view the focal area of the component, and an additive material delivery means that delivers additive material to the component at the focal area on the component. In certain embodiments, the focal area of the component is between blades on a bladed wheel. In certain embodiments, the deposition device has a width of less than one inch. In certain embodiments, the imaging device views the focal area of the component down the axis of the deposition device from a close proximity to the component. In certain embodiments, the imaging device views the focal area of the component from within 2 inches of the component. In certain further embodiments, the imaging device views the focal area of the component through the directing optics. In certain embodiments, the imaging device includes a coaxial viewing element in the deposition device.

In certain embodiments, a lighting device is structured to deliver light to the component at the focal area on the component. The lighting device may be a light operatively coupled to the deposition device that shines down a body tube of the deposition device, a laser diode on the deposition device, and/or a light-emitting diode coupled to the deposition device. In certain embodiments, the laser includes an Nd:YAG fiber-optic laser. The final focusing optics may be more than one centimeter distant from the focal area of the component, and in certain embodiments, the final focusing optics have a focal length greater than 40 cm.

A method is disclosed including interpreting a target geometry for a component and positioning a deposition device operatively coupled to a laser, where the deposition device includes directing optics structured to focus the laser at a focal area on a component. The method further includes positioning an imaging device structured to view the focal area of the component, positioning an additive material delivery means that delivers additive material to the component at the focal area of the component, generating a deposition tool path according to the target geometry of the component; and controlling movement of the deposition device according to the deposition tool path. The method further includes depositing additive material on a surface of the component in response to the controlling movement of the deposition device. In certain embodiments, the additive material is titanium and/or a titanium alloy.

In certain embodiments, the directing optics include a prism. In certain embodiments, the imaging device views the focal area of the component through the directing optics. In certain embodiments, the method includes generating a deposition tool path according to the target geometry of the component by performing a teach-and-learn operation. In certain embodiments, the focal area on the component includes an area on a bladed disk between two blades. In certain embodiments, the method includes operating the laser and flowing a shield gas over the focusing optics in response to the operation of the laser.

A system is disclosed including a deposition device operatively coupled to a fiber optic Nd:YAG laser, where the deposition device includes a directing prism structured to direct the Nd:YAG laser at a focal area on a bladed disk, wherein the focal area on the bladed disk is disposed between two blades of the disk. In certain embodiments, the system includes an imaging means that views the focal area of the component, where the imaging means and the fiber optic Nd:YAG laser each are positioned in a substantially similar optical relationship to the focal area on the bladed disk. In certain embodiments, the system further includes an additive material delivery means that delivers additive material to the component at the focal area on the component.

In certain embodiments, the imaging means views the focal area of the component through the directing prism. In certain embodiments, the system further includes means for generating a deposition device tool path, and a means for operating the deposition device in response to the deposition device tool path. The system may include final focusing optics positioned more than one centimeter distant from the focal area of the component. In certain embodiments, the deposition device includes a deposition head having a width less than one inch. In certain embodiments, the additive delivery means includes a metal powder delivery device disposed in the deposition head. In certain embodiments, the system further includes a shield coupled to the deposition device, the shield structured to prevent a reflected portion of the Nd:YAG laser from melting an opposing surface to the focal area.

In certain embodiments, the system includes a cooling passage disposed in the deposition device, the cooling passage structured to allow coolant to pass through the deposition device and dissipate heat generated from a reflected portion of the Nd:YAG laser. In certain embodiments, the Nd:YAG laser further includes an irradiance value at the focal area of the component, wherein the irradiance value is at least 2 megaWatts/cm².30. In certain embodiments, the system includes a purge gas delivery device structured to flow a shield gas, or purge gas, across the final optics.

## Claims

1. A system, comprising:
- a deposition device (102) operatively coupled to a laser (104), the deposition device (102) comprising directing optics for directing the laser (104) at a focal area (106) on a component (108);
- an imaging device (112) structured to view the focal area (106) of the component, and
- an additive material delivery means that delivers additive material (118) to the component at the focal area on the component,
**characterized in that** the directing optics comprise a prism (110) structured to direct the laser at the focal area (106) on the component (108).

2. The system of claim 1, wherein the component (108) is a bladed wheel and the focal area (106) on the component (108) is between blades on the bladed wheel.

3. The system of claim 1 or 2, wherein the deposition device (102) has a width of less than one inch.

4. The system of any one of claims 1 to 3, wherein the imaging device (112) views the focal area (106) of the component (108) through the directing optics.

5. The system of any one of claims 1 to 4, wherein the imaging device (112) includes a coaxial viewing element in the deposition device (102).

6. The system of any one of claims 1 to 5, further comprising a lighting device (126), wherein the lighting device is structured to deliver light to the component (108) at the focal area (106) on the component, and/or
wherein the lighting device (126) comprises one of a light operatively coupled to the deposition device (102) that shines down a body tube of the deposition device, and a laser diode on the deposition device.

7. The system of any one of claims 1 to 6, wherein the laser (104) comprises an Nd:YAG fiber-optic laser.

8. The system of any one of claims 1 to 7, further comprising final focusing optics (124) wherein the final focusing optics include a focal length greater than 40 cm.

9. The system of any one of claims 1 to 8, further comprising means for generating a deposition device tool path, and a means for operating the deposition device in response to the deposition device tool path.

10. The system of any one of claims 1 to 8, wherein the additive material delivery means includes a metal powder delivery device disposed in the deposition head.

11. The system of claim 7, further comprising a shield (128) coupled to the deposition device (102), the shield structured to prevent a reflected portion of the Nd:YAG laser from melting an opposing surface to the focal area (106).

12. The system of claim 7, further comprising a cooling passage (130) disposed in the deposition device (102), the cooling passage structured to allow coolant to pass through the deposition device and dissipate heat generated from a reflected portion of the Nd:YAG laser.

13. The system of claim 12, wherein the Nd:YAG laser further includes an irradiance value at the focal area of the component, wherein the irradiance value is at least 2 megaWatts/cm².

14. The system of any one of claims 1 to 7, 9, 10, 11, 12 or 13 further comprising a purge gas delivery device (136) structured to flow a purge gas (138) across a final focusing optics.

15. A method, comprising:
- interpreting a target geometry for a component,
- positioning a deposition device operatively coupled to a laser, the deposition device comprising directing optics structured to focus the laser at a focal area on a component, the directing optics including a prism,
- positioning an imaging device structured to view the focal area of the component,
- positioning an additive material delivery means that delivers additive material to the component at the focal area of the component,
- generating a deposition tool path according to the target geometry of the component, and
- controlling movement of the deposition device according to the deposition tool path, and
- depositing additive material on a surface of the component in response to the controlling movement of the deposition device.

16. The method of claim 15, wherein the imaging device views the focal area of the component through the directing optics.

17. The method of claim 15 or 16, wherein the additive material comprises one of titanium and a titanium alloy.

18. The method of any one of claims 15 to 17, wherein the focal area on the component comprises an area on a bladed disk between two blades.

19. The method of claim 16, further comprising flowing shield gas over the directing optics.

## Patentansprüche

1. System, mit:
- einer betriebsfähig mit einem Laser (104) verbundenen Auftragungseinrichtung (102), wobei die Auftragungseinrichtung (102) eine Richtoptik zum Richten des Lasers (104) auf einen Fokusbereich (106) auf einem Bauteil (108) umfasst,
- einer Bildgebungseinrichtung (112), die dazu aufgebaut ist, den Fokusbereich (106) des Bauteils zu betrachten, und
- einer Auftragungsmaterialabgabeeinrichtung, die Auftragungsmaterial (118) zu dem Bauteil in den Fokusbereich auf dem Bauteil liefert,
**dadurch gekennzeichnet, dass** die Richtoptik ein Prisma (110) aufweist, welches dazu aufgebaut ist, den Laser auf den Fokusbereich (106) des Bauteils (108) zu richten.

2. System nach Anspruch 1, bei dem das Bauteil (108) ein Schaufelrad ist und der Fokusbereich (106) auf dem Bauteil (108) sich zwischen Schaufeln auf dem Schaufelrad befindet.

3. System nach Anspruch 1 oder 2, bei dem die Auftragungseinrichtung (102) eine Breite von weniger als einem Inch hat.

4. System nach einem der Ansprüche 1 bis 3, bei dem die Bildgebungseinrichtung (112) den Fokusbereich (106) des Bauteils (108) durch die Richtoptik betrachtet.

5. System nach einem der Ansprüche 1 bis 4, bei dem die Bildgebungseinrichtung (112) ein koaxiales Betrachtungselement in der Auftragungseinrichtung (102) umfasst.

6. System nach einem der Ansprüche 1 bis 5, ferner umfassend eine Beleuchtungseinrichtung (126), wobei die Beleuchtungseinrichtung dazu aufgebaut ist, Licht zum Bauteil (108) in den Fokusbereich (106) auf dem Bauteil zu liefern und/oder wobei die Beleuchtungseinrichtung (126) eine betriebsfähig mit der Auftragungseinrichtung (102) verbundene Lampe, die durch ein Gehäuserohr der Auftragungseinrichtung scheint, oder eine Laserdiode auf der Auftragungseinrichtung aufweist.

7. System nach einem der Ansprüche 1 bis 6, bei dem der Laser (104) einen faseroptischen Nd:YAG-Laser umfasst.

8. System nach einem der Ansprüche 1 bis 7, ferner umfassend eine Endfokussieroptik (124), wobei die Endfokussieroptik eine Brennweite größer als 40 cm hat.

9. System nach einem der Ansprüche 1 bis 8, ferner umfassend Mittel zum Generieren eines Auftragungseinrichtungswerkzeugweges und eine Einrichtung zum Betreiben der Auftragungseinrichtung in Antwort auf den Auftragungseinrichtungswerkzeugweg.

10. System nach einem der Ansprüche 1 bis 8, bei dem die Auftragungsmaterialabgabeeinrichtung eine Metallpulverzuführeinrichtung umfasst, die in dem Auftragungskopf angeordnet ist.

11. System nach Anspruch 7, ferner umfassend einen mit der Auftragungseinrichtung (102) verbundenen Schirm (128), wobei der Schirm dazu aufgebaut ist, einen reflektierten Anteil des Nd:YAG-Lasers daran zu hindern, eine dem Fokusbereich (106) gegenüberliegende Oberfläche aufzuschmelzen.

12. System nach Anspruch 7, ferner umfassend einen in der Auftragungseinrichtung (102) angeordneten Kühlkanal (130), wobei der Kühlkanal dazu aufgebaut ist, ein Kühlmittel durch die Auftragungseinrichtung strömen zu lassen und von einem reflektierten Anteil des Nd:YAG-Lasers erzeugte Wärme zu dissipieren.

13. System nach Anspruch 12, bei dem der Nd:YAG-Laser ferner einen Bestrahlungsstärkewert in dem Fokusbereich des Bauteils aufweist, wobei der Bestrahlungsstärkewert wenigstens 2 megaWatt/cm² beträgt.

14. System nach einem der Ansprüche 1 bis 7, 9, 10, 11, 12 oder 13, ferner umfassend eine Spülgaszufuhreinrichtung (136), die dazu aufgebaut ist, ein Spülgas (138) über eine Endfokussieroptik strömen zu lassen.

15. Verfahren, umfassend:
- Auswerten einer Zielgeometrie für ein Bauteil,
- Positionieren einer betriebsfähig mit einem Laser verbundenen Auftragungseinrichtung, wobei die Auftragungseinrichtung eine Richtoptik umfasst, die dazu aufgebaut ist, den Laser auf einen Fokusbereich auf einem Bauteil zu fokussieren, wobei die Richtoptik ein Prisma aufweist,
- Positionieren einer Bildgebungseinrichtung, die dazu aufgebaut ist, den Fokusbereich des Bauteils zu betrachten,
- Positionieren einer Auftragungsmaterialabgabeeinrichtung, die Auftragungsmaterial zu dem Bauteil in den Fokusbereich auf dem Bauteil liefert,
- Generieren eines Auftragungswerkzeugweges gemäß der Zielgeometrie des Bauteils, und
- Steuern einer Bewegung der Auftragungseinrichtung entsprechend dem Auftragungswerkzeugweg, und
- Auftragen von Auftragungsmaterial auf eine Oberfläche des Bauteils in Reaktion auf die gesteuerte Bewegung der Auftragungseinrichtung.

16. Verfahren nach Anspruch 15, bei dem die Bildgebungseinrichtung den Fokusbereich des Bauteils durch die Richtoptik betrachtet.

17. Verfahren nach Anspruch 15 oder 16, bei dem das Auftragungsmaterial Titan oder eine Titanlegierung umfasst.

18. Verfahren nach einem der Ansprüche 15 bis 17, wobei der Fokusbereich auf dem Bauteil einen Bereich auf einem Blisk zwischen zwei Schaufeln ist.

19. Verfahren nach Anspruch 16, ferner umfassend ein Strömenlassen von Schutzgas über die Richtoptik.

## Revendications

1. Système, comprenant :
- un dispositif de dépôt (102) opérationnellement couplé à un laser (104), le dispositif de dépôt (102) comprenant une optique d'orientation pour diriger le laser (104) au niveau d'un foyer (106) sur un composant (108) ;
- un dispositif d'imagerie (112) structuré pour visualiser le foyer (106) du composant, et
- un moyen de délivrance de matière additive qui délivre une matière additive (118) pour le composant au niveau du foyer sur le composant,
**caractérisé en ce que** l'optique d'orientation comprend un prisme (110) structuré pour diriger le laser au niveau du foyer (106) sur le composant (108).

2. Système selon la revendication 1, dans lequel le composant (108) est une roue à ailettes et le foyer (106) sur le composant (108) est entre des ailettes sur la roue à ailettes.

3. Système selon la revendication 1 ou 2, dans lequel le dispositif de dépôt (102) a une largeur de moins d'un pouce.

4. Système selon l'une quelconque des revendications 1 à 3, dans lequel le dispositif d'imagerie (112) visualise le foyer (106) du composant (108) à travers l'optique d'orientation.

5. Système selon l'une quelconque des revendications 1 à 4, dans lequel le dispositif d'imagerie (112) inclut un élément de visualisation coaxial dans le dispositif de dépôt (102).

6. Système selon l'une quelconque des revendications 1 à 5, comprenant en outre un dispositif d'éclairage (126), dans lequel le dispositif d'éclairage est structuré pour délivrer une lumière sur le composant (108) au niveau du foyer (106) sur le composant, et/ou
dans lequel le dispositif d'éclairage (126) comprend une parmi une lumière opérationnellement couplée au dispositif de dépôt (102) qui éclaire un tube de corps du dispositif de dépôt, et une diode laser sur le dispositif de dépôt.

7. Système selon l'une quelconque des revendications 1 à 6, dans lequel le laser (104) comprend un laser sur fibre optique Nd:YAG.

8. Système selon l'une quelconque des revendications 1 à 7, comprenant en outre une optique de focalisation finale (124), dans lequel l'optique de focalisation finale inclut une longueur focale supérieure à 40 cm.

9. Système selon l'une quelconque des revendications 1 à 8, comprenant en outre un moyen pour générer un chemin d'outil de dispositif de dépôt, et un moyen pour opérer le dispositif de dépôt en réponse au chemin d'outil de dispositif de dépôt.

10. Système selon l'une quelconque des revendications 1 à 8, dans lequel le moyen de délivrance de matière additive inclut un dispositif de délivrance de poudre de métal disposé dans la tête de dépôt.

11. Système selon la revendication 7, comprenant en outre un écran de protection (128) couplé au dispositif de dépôt (102), l'écran de protection structuré de façon à empêcher qu'une partie réfléchie du laser Nd:YAG ne fasse fondre une surface opposée au foyer (106).

12. Système selon la revendication 7, comprenant en outre un passage de refroidissement (130) disposé dans le dispositif de dépôt (102), le passage de refroidissement structuré de façon à permettre qu'un réfrigérant passe à travers le dispositif de dépôt et dissipe une chaleur générée à partir d'une partie réfléchie du laser Nd:YAG.

13. Système selon la revendication 12, dans lequel le laser Nd:YAG inclut en outre une valeur d'éclairement énergétique au niveau du foyer du composant, dans lequel la valeur d'éclairement énergétique est au moins 2 mégawatts/cm².

14. Système selon l'une quelconque des revendications 1 à 7, 9, 10, 11, 12 ou 13 comprenant en outre un dispositif de délivrance de gaz de purge (136) structuré pour faire s'écouler un gaz de purge (138) à travers une optique de focalisation finale.

15. Procédé, comprenant :
- l'interprétation d'une géométrie de cible pour un composant,
- le positionnement d'un dispositif de dépôt opérationnellement couplé à un laser, le dispositif de dépôt comprenant une optique d'orientation structurée pour focaliser le laser au niveau d'un foyer sur un composant, l'optique d'orientation incluant un prisme,
- le positionnement d'un dispositif d'imagerie structuré pour visualiser le foyer du composant,
- le positionnement d'un moyen de délivrance de matière additive qui délivre une matière additive sur le composant au niveau du foyer du composant,
- la génération d'un chemin d'outil de dépôt en fonction de la géométrie de cible du composant, et
- la commande du mouvement du dispositif de dépôt en fonction du chemin d'outil de dépôt, et
- le dépôt d'une matière additive sur une surface du composant en réponse à la commande du mouvement du dispositif de dépôt.

16. Procédé selon la revendication 15, dans lequel le dispositif d'imagerie visualise le foyer du composant à travers l'optique d'orientation.

17. Procédé selon la revendication 15 ou 16, dans lequel la matière additive comprend un parmi du titane et un alliage de titane.

18. Procédé selon l'une quelconque des revendications 15 à 17, dans lequel le foyer sur le composant comprend une zone sur un disque à ailettes entre deux ailettes.

19. Procédé selon la revendication 16, comprenant en outre l'écoulement d'un gaz de protection sur l'optique d'orientation.
